**Europäisches Patentamt**

**European Patent Office**

**Office européen des brevets**

(11) Numéro de publication : **0 093 034**
**B1**

# (12) FASCICULE DE BREVET EUROPÉEN

(45) Date de publication du fascicule du brevet :
**12.02.86**

(21) Numéro de dépôt : **83400724.7**

(22) Date de dépôt : **12.04.83**

(51) Int. Cl.⁴ : **H 03 H 15/02, G 11 C 27/02**

(54) **Filtre transversal à transfert de charge.**

(30) Priorité : **23.04.82 FR 8207062**

(43) Date de publication de la demande :
**02.11.83 Bulletin 83/44**

(45) Mention de la délivrance du brevet :
**12.02.86 Bulletin 86/07**

(84) Etats contractants désignés :
**DE GB NL**

(56) Documents cités :
**FR-A- 2 271 716**
**FR-A- 2 453 543**

(73) Titulaire : **THOMSON-CSF**
**173, Boulevard Haussmann**
**F-75379 Paris Cedex 08 (FR)**

(72) Inventeur : **Beal, Gérard**
**THOMSON-CSF SCPI 173, bld Haussmann**
**F-75379 Paris Cedex 08 (FR)**
Inventeur : **Coutures, Jean-Louis**
**THOMSON-CSF SCPI 173, bld Haussmann**
**F-75379 Paris Cedex 08 (FR)**

(74) Mandataire : **Ruellan-Lemonnier, Brigitte et al**
**THOMSON-CSF SCPI 173, boulevard Haussmann**
**F-75379 Paris Cedex 08 (FR)**

Jouve, 18, rue St-Denis, 75001 Paris, France

**Description**

La présente invention concerne un filtre transversal à transfert de charge.

On entend par filtre transversal élémentaire à transfert de charge un ensemble d'étages de retard, à l'entrée duquel est appliqué le signal à filtrer, le signal filtré étant obtenu en effectuant la somme de l'ensemble des signaux de sortie des différents étages de retard, multipliés par des coefficients de pondération.

On entend par filtre transversal complexe à transfert de charge un ensemble de filtres transversaux élémentaires à transfert de charge à l'entrée desquels sont appliqués différents signaux à filtrer, le signal filtré étant obtenu en effectuant la somme des signaux de sortie de tous les étages de retard des différents filtres élémentaires.

Par la suite, le terme filtre désigne indifféremment un filtre élémentaire ou un filtre complexe.

Chaque étage de retard est réalisé au moyen d'un ensemble de capacités MOS disposées de manière adjacente sur un même substrat semi-conducteur, l'une de ces capacités étant munie d'une électrode affectée à la lecture de charge, les autres capacités étant munies d'électrodes affectées à la commande du transfert de charge. Le nombre de capacités MOS affectées à la commande du transfert de charge varie essentiellement avec la technologie du filtre et avec le nombre de phases de commande utilisé.

Pour éviter toute discontinuité dans le transfert de charge entre les différents étages, et, à l'intérieur de chaque étage, entre les différentes capacités MOS de cet étage, des discontinuités dans la disposition des électrodes successives doivent être évitées.

Pour cela il est connu de faire se recouvrir les extrémités d'électrodes adjacentes, un isolant étant alors prévu pour éviter tout contact entre électrodes dans la zone de recouvrement.

Le recouvrement d'une électrode de lecture par deux électrodes de commande adjacentes perturbe la lecture de la quantité de charge qui se trouve sous cette électrode de lecture.

En effet, quelle que soit la méthode de lecture utilisée, (lecture en courant avec électrode de lecture à tension fixe ou lecture en tension avec électrode de lecture flottante) et quel que soit le nombre d'électrodes de commande par étage de retard, une variation de potentiel doit se produire au cours de l'opération de lecture, sur l'une au moins des deux électrodes de commande entourant l'électrode de lecture considérée, de manière à assurer le transfert de charge sous cette électrode de lecture. Et cette variation de potentiel est transmise à l'électrode de lecture par l'intermédiaire du condensateur constitué par les extrémités de l'électrode de lecture et de l'électrode de commande se recouvrant, et par la couche d'isolant intercalée entre ces extrémités.

Cette perturbation de la lecture se traduit par l'adjonction d'une composante continue à la composante alternative provenant de la lecture proprement dite de la charge située sous l'électrode de lecture considérée. La valeur de cette composante continue dépend des largeurs de recouvrement (prises dans le sens longitudinal du filtre) de l'électrode de lecture considérée par les électrodes de commande adjacentes sur lesquelles interviennent des variations de potentiel au cours de la lecture. Les différentes électrodes de lecture du filtre étant reliées entre elles, les perturbations correspondant à ces différentes électrodes de lecture s'ajoutent.

Lors de la fabrication d'un filtre, les largeurs de recouvrement entre électrodes sont fixées pour toutes les électrodes du filtre, par le positionnement, par rapport aux électrodes dont les extrémités sont destinées à être recouvertes, d'un masque dont les parties non évidées ont pour rôle de préserver les parties non destinées à être recouvertes.

Un problème se pose alors du fait que le positionnement de ce masque peut varier d'un filtre à un autre présentant par ailleurs des caractéristiques de construction identiques. En effet, si le positionnement du masque varie, la composante continue de lecture varie aussi. Or, pour faciliter l'acquisition du signal de lecture, on a intérêt à avoir la même composante continue de lecture d'un filtre à un autre. Ceci est d'autant plus vrai qu'en pratique un très faible écart dans le positionnement du masque se traduit par une variation de composante continue relativement importante.

La présente invention vise à résoudre ce problème.

Selon l'invention, le filtre transversal à transfert de charge, comportant N capacités du type MOS disposées sur un même substrat semi-conducteur, et réparties en étages de retard, les capacités MOS de chaque étage de retard étant munies l'une d'une électrode de lecture et les autres d'électrodes de commande, et une électrode sur deux ayant ses extrémités recouvertes par les extrémités des deux électrodes adjacentes, ce filtre est tel que les N capacités MOS sont disposées en n rangées (avec n pair) numérotées de 1 à n, à raison de N/n capacités MOS par rangée, les capacités MOS de chaque rangée étant numérotées de 1 à N/n en suivant le sens de transfert de charge dans la rangée numéro 1, les sens de transfert de charge dans deux rangées adjacentes étant opposés, ce qui permet de compenser les effets dus aux décalages des masques utilisés pour la fabrication des filtres transversaux à transfert de charge.

Les objets et caractéristiques de la présente invention apparaîtront plus clairement à la lecture de la description suivante d'un exemple de réalisation, ladite description étant faite en relation avec les dessins ci-annexés dans lesquels :

la figure 1 est une vue de dessus schématique d'un filtre transversal à transfert de charge selon l'art antérieur ;

la figure 2 est une coupe longitudinale du filtre représenté sur la figure 1 ;

la figure 3 est un schéma électrique équivalent du filtre représenté sur les figures 1 et 2 ;

la figure 4 est une vue de dessus schématique d'un filtre transversal à transfert de charge selon l'invention ;

la figure 5 est un ensemble de coupes longitudinales de différentes rangées constituant le filtre représenté sur la figure 4.

A titre d'exemple la description est faite pour une technologie dite à dissymétrie d'implantation, (ces dissymétries n'étant pas représentées sur les dessins), pour un nombre de phases de commande égal à deux et pour des électrodes de lecture à simple coupure, mais il fut souligner que le principe de l'invention est également applicable à la technologie dite à surépaisseur d'oxyde, à un nombre de phases de commande quelconque, et à des électrodes de lecture à double coupure.

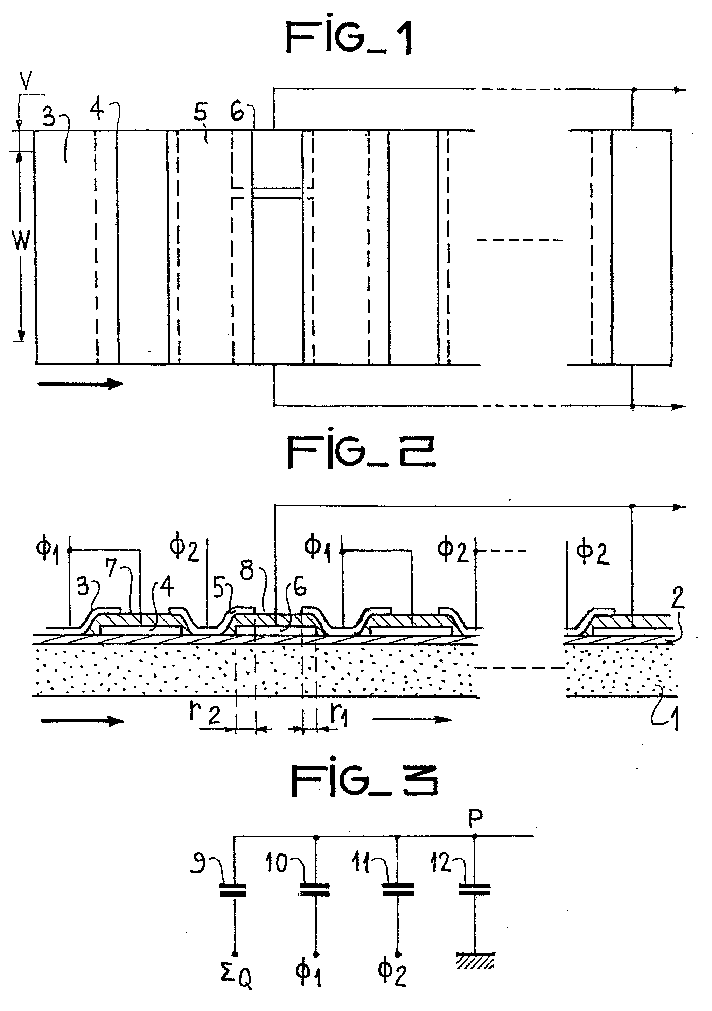

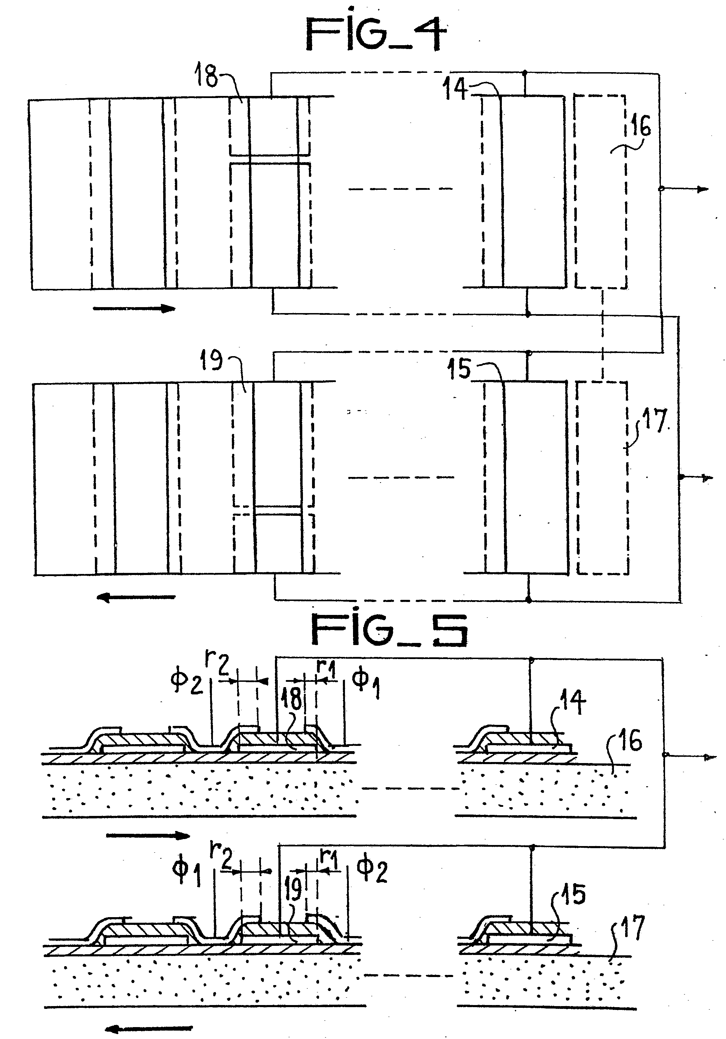

Sur les figures 1 et 2 on a représenté un filtre transversal à transfert de charge selon l'art antérieur. Il s'agit à titre d'exemple d'un filtre élémentaire. Ce filtre comporte N capacités MOS disposées de manière adjacente sur un même substrat semiconducteur 1 recouvert d'une couche d'oxyde 2.

Ces N capacités MOS sont réparties en étages de retard, chaque étage de retard comportant par exemple, comme illustré sur les figures 1 et 2, une capacité MOS munie d'une électrode de lecture et trois capacités MOS munies d'une électrode de commande. Si l'on désigne par M le nombre de capacités MOS par étage de retard, le filtre comporte N/M étages de retard. Dans ce cas le filtre comporte N/4 étages de retard identiques dont seul le premier est représenté en entier sur les figures 1 et 2, et décrit dans ce qui suit.

Ce premier étage comporte, en suivant le sens de transfert de charge représenté par une flèche orientée de gauche à droite sur les figures 1 et 2, une première capacité MOS munie d'une électrode de commande 3, dite électrode de transfert, une deuxième capacité MOS munie d'une électrode de commande 4, dite électrode de stockage, une troisième capacité MOS munie d'une électrode de commande 5, dite également électrode de transfert, et une quatrième capacité MOS munie d'une électrode de lecture 6. En dehors des périodes réservées à la lecture, l'électrode de lecture remplit également grâce à un montage approprié (non représenté), la fonction d'électrode de stockage.

Sur les électrodes de transfert 3 et de stockage 4 est appliqué un potentiel périodique $\phi_1$. Sur l'électrode de transfert 5 est appliqué un potentiel périodique $\phi_2$.

Comme cela est représenté sur la figure 1, une coupure est pratiquée dans chaque électrode de lecture, à des niveaux propres à chacune de ces électrodes de lecture, les portions d'électrodes de lecture supérieures et inférieures étant respectivement reliées entre elles. Ceci permet de faire une sommation des charges présentes au même instant dans les différents étages de retard, multipliées respectivement par des coefficients de pondération déterminés par la position des différentes coupures.

Une électrode sur deux a ses extrémités recouvertes par les extrémités des électrodes adjacentes. Ainsi, dans l'exemple montré sur les figures 1 et 2, l'électrode de stockage 4 a ses extrémités recouvertes par l'extrémité droite de l'électrode de transfert 3 et par l'extrémité gauche de l'électrode de transfert 5. De même l'électrode de lecture 6 a ses extrémités recouvertes par l'extrémité droite de l'électrode de transfert 5 et par l'extrémité gauche de la première électrode de transfert du deuxième étage de retard.

Une couche d'oxyde isolant 7 est prévue entre l'électrode de stockage 4 et les extrémités recourbées des électrodes qui lui sont adjacentes. De même une couche d'oxyde isolant 8 est prévue entre l'électrode de lecture 6 et les extrémités recourbées des électrodes qui lui sont adjacentes.

Au cours de la fabrication d'un tel filtre, lorsqu'on procède au dépôt de la couche métallique finale, correspondant aux électrodes telles que les électrodes 3 et 5 pour le premier étage de retard, on a recours à un masque pour préserver les parties des couches d'oxyde isolant, telles que les couches 7 et 8 pour le premier étage de retard, non destinées à être recouvertes par cette couche métallique finale. Le positionnement de ce masque détermine les largeurs de recouvrement (prises dans le sens longitudinal) d'une électrode par les électrodes qui lui sont adjacentes.

Ainsi le positionnement du masque ayant servi à la fabrication du filtre représenté sur les figures 1 et 2 a déterminé une largeur de recouvrement $r_2$ pour les extrémités gauche de toutes les électrodes recouvertes (telles que les électrodes 4 et 6 pour le premier étage de retard) et une largeur de recouvrement $r_1$ pour les extrémités droite de ces électrodes. L'influence de ce recouvrement sur la lecture est maintenant expliqué en relation avec la figure 3 qui représente le schéma électrique équivalent du filtre.

Sur ce schéma on a représenté un point P qui est le point commun à l'ensemble des portions supérieures ou inférieures des électrodes de lecture du filtre, l'influence du recouvrement sur la lecture étant la même dans les deux cas. Ce point P est réuni à une première borne de quatre condensateurs 9, 10, 11, 12.

Le condensateur 9 est muni d'une seconde borne qui reçoit la somme $\Sigma Q$ des charges présentes sous les différentes électrodes de lecture du filtre. Le condensateur 9 a une capacité $C_{ox}$ égale à la capacité d'oxyde d'isolement des électrodes de lecture par rapport au canal de transfert de charge.

Le condensateur 10 est muni d'une seconde borne qui reçoit le potentiel $\phi_1$, et a une capacité $\Sigma C_{r_1}$ égale à la somme des capacités de recouvrement $C_{r_1}$ des électrodes de commande adjacentes sur lesquelles est appliqué le potentiel $\phi_1$.

Le condensateur 11 est muni d'une seconde borne qui reçoit le potentiel $\phi_2$, et a une capacité $\Sigma C_{r_2}$

égale à la somme des capacités de recouvrement $C_{r_2}$ des électrodes de lecture par les électrodes de commande adjacentes sur lesquelles est appliqué le potentiel $\phi_2$.

Le condensateur 12 est muni d'une seconde borne reliée à la masse, et a une capacité $C_p$ égale à la somme des capacités parasites constantes dues à des phénomènes autres que les recouvrements.

Lors de la lecture de l'ensemble des charges il se produit au point P, en cas de lecture en tension, une variation de potentiel qui s'exprime de la façon suivante :

$$V_P = \frac{\sum Q}{C_P + \sum C_{r_1} + \sum C_{r_2}} + \frac{\sum C_{r_1}}{C_P + \sum C_{r_1} + \sum C_{r_2}} \Delta\phi_1 + \frac{\sum C_{r_2}}{C_P + \sum C_{r_1} + \sum C_{r_2}} \Delta\phi_2$$

En cas de lecture en courant, il se produit une variation de charge qui s'exprime de la façon suivante :

$$Q_P = \sum Q + \sum C_{r_1} \Delta\phi_1 + \sum C_{r_2} \Delta\phi_2 \, .$$

Dans ces deux expressions, $\Delta\phi_1$ et $\Delta\phi_2$ représentent les variations de potentiel de $\phi_1$ et $\phi_2$ lors de la lecture des charges. Par exemple, dans le cas de deux phases de commande, $\Delta\phi_1$ et $\Delta\phi_2$ sont des signes opposés, et dans le cas d'une phase de commande $\Delta\phi_2$ est nul.

Les capacités de recouvrement $\Sigma C_{r_1}$ et $\Sigma C_{r_2}$ sont fonction du nombre d'étages de retard N/M du filtre.

Pour un filtre à simple coupure d'électrode de lecture, on a :

$$\sum C_{r_1} = \gamma r_1 \frac{W}{2} \left[ \frac{N}{M} + \delta \sum_{i=1}^{N/M} h_i \right] + \gamma r_1 \frac{N}{M} V$$

$$\sum C_{r_2} = \gamma r_2 \frac{W}{2} \left[ \frac{N}{M} + \delta \sum_{i=1}^{N/M} h_i \right] + \gamma r_2 \frac{N}{M} V$$

Dans ces deux expressions, $\gamma$ est un terme constant étal à $\varepsilon/e$, où $\varepsilon$ est la constante diélectrique des couches d'oxyde isolant telles que 7 et 8 pour le premier étage de retard et e l'épaisseur de ces couches.

W est la largeur (prise dans le sens transversal) du canal de transfert de charge, telle que représentée sur la figure 1.

$\delta$ est également un terme constant égal à $1 - (2g/W)$, où g est la garde des coupures au bord du canal pour des coefficients égaux à $+ 1$ ou à $- 1$.

V représente la largeur (prise dans le sens transversal) de débordement des électrodes par rapport au canal.

$$\sum_{i=1}^{N/M} h_i$$

représente la somme des coefficients de pondération correspondant aux différentes électrodes de lecture, i étant un indice variant de 1 à N/M, où N/M est le nombre d'étages de retard du filtre.

Le terme :

$$\frac{\sum C_{r_1} \Delta\phi_1}{C_P + \sum C_{r_1} + \sum C_{r_2}} + \frac{\sum C_{r_2} \Delta\phi_2}{C_P + \sum C_{r_1} + \sum C_{r_2}}$$

dans l'expression de la variation de tension $V_p$ au point P, ou

$$\sum C_{r_1} \Delta\phi_1 + \sum C_{r_2} \Delta\phi_2$$

dans l'expression de la variation de charge $Q_p$ au point P, correspond à une composante continue qui vient s'ajouter à la composante alternative

$$\frac{\sum Q}{C_P + \sum C_{r_1} + \sum C_{r_2}} \quad \text{ou} \quad \sum Q \, .$$

Cette composante continue est donc fonction des largeurs de recouvrement $r_1$ et $r_2$ qui sont elles-mêmes déterminées par le positionnement du masque. Or le positionnement du masque peut varier d'un filtre à un autre présentant par ailleurs des caractéristiques de construction identiques.

Avec un filtre conforme à l'art antérieur la composante continue est donc susceptible de varier dans des proportions relativement importantes d'un filtre à un autre, ce qui est gênant pour l'acquisition des signaux de lecture.

Le filtre conforme à la présente invention permet d'avoir une composante continue pratiquement constante d'un filtre à un autre.

Sur les figures 4 et 5 on a représenté un exemple de réalisation d'un filtre conforme à la présente invention. Les N capacités MOS du filtre conforme à l'invention sont disposées suivant n rangées de N/n capacités chacune.

Pour plus de clarté on a représenté seulement deux rangées sur les figures 4 et 5. Ces rangées représentent indifféremment deux filtres élémentaires consécutifs, non disposés en rangées, d'un même filtre complexe, ou deux rangées adjacentes d'un même filtre élémentaire, ou encore la dernière et la première rangée de deux filtres élémentaires consécutifs faisant partie d'un même filtre complexe.

Les N/n capacités MOS de chaque rangée sont numérotées de 1 à N/n en suivant le sens de transfert de charge choisi pour la première rangée (par exemple de gauche à droite comme représenté à l'aide d'une flèche sous la première rangée).

Dans le cas de deux rangées adjacentes d'un même filtre élémentaire, la continuité entre la Nième/n capacité MOS de la première rangée, qui est munie d'une électrode 14, et la Nième/n capacité MOS de la deuxième rangée, qui est munie d'une électrode 15, est assurée par une première et une deuxième diodes 16 et 17 localisées respectivement dans le substrat semi-conducteur de la première et de la deuxième rangées et reliées entre elles. La nature des électrodes 14 et 15 est telle que ce ne sont pas des électrodes de lecture et que sur le trajet emprunté par les charges entre la dernière électrode de lecture rencontrée sur une rangée et la première électrode de lecture rencontrée sur la rangée suivante se trouvent trois électrodes telles que les électrodes 3, 4 et 5 des figures 1 et 2, c'est-à-dire une électrode de transfert, une électrode de stockage, puis une électrode de transfert. De plus, par une commande adéquate des électrodes de commande, le sens de transfert de charge dans la deuxième rangée est inversé par rapport à la première rangée (comme montré à l'aide de flèches sur les figures 4 et 5).

Plus généralement, pour n rangées adjacentes d'un même filtre élémentaire, avec n pair, la Nième/n capacité MOS de chaque rangée de numéro impair est reliée, par l'intermédiaire de diodes, à la Nième/n capacité MOS de la rangée suivante, et la première capacité MOS de chaque rangée de numéro pair est reliée à la première capacité MOS de la rangée suivante. De plus, par une commande adéquate des électrodes de commande, les sens de transfert de charge dans deux rangées adjacentes sont opposés.

Dans le cas d'un filtre complexe, les signaux à filtrer sont introduits, et les électrodes de commande commandées, de manière que les sens de transfert de charge dans deux rangées adjacentes soient opposés. Dans le cas où les filtres élémentaires d'un même filtre complexe ne sont pas eux-mêmes disposés en rangées, le fait que les signaux à filtrer soient introduits de manière telle que les sens de transfert de charge dans deux rangées adjacentes soient opposés se traduit par le fait que les étages d'entrée de deux rangées adjacentes sont situées à des extrémités opposées de ces deux rangées. On rappelle que les étages d'entrée ont pour rôle d'effectuer la transformation des signaux d'entrée en charges.

De plus, dans le cas où les filtres élémentaires d'un même filtre complexe ne sont pas disposés en rangées, il n'y a pas de liaison entre les différentes rangées qui représentent alors les différents filtres élémentaires. C'est pour cette raison que les diodes 16 et 17 et les liaisons entre ces deux diodes n'ont été représentées qu'en pointillés sur la figure 4.

Dans le cas où les filtres élémentaires d'un même filtre complexe sont à leur tour disposés en rangées, la dernière rangée de chaque filtre élémentaire n'est pas reliée à la première rangée du filtre élémentaire suivant.

Les portions supérieures des électrodes de lecture des différentes rangées constituant le filtre sont reliées entre elles et il en est de même pour les portions inférieures de ces électrodes.

Les extrémités d'électrodes appartenant à des capacités MOS de même numéro sur différentes rangées peuvent ou non être alignées.

Toutes les électrodes de lecture de toutes les rangées du filtre ont une même largeur de recouvrement $r_1$ de leur extrémité droite et une même largeur de recouvrement $r_2$ de leur extrémité gauche. Cependant, à l'inverse du filtre représenté sur les figures 1 et 2, le potentiel appliqué sur les électrodes de commande dont l'extrémité recouvre l'extrémité gauche des électrodes de lecture, n'est pas toujours égal à $\phi_2$, mais du fait de l'inversion du sens de transfert de charge d'une rangée à une autre, est alternativement égal à $\phi_1$ et $\phi_1$. De même, à l'inverse du filtre représenté sur les figures 1 et 2, le potentiel appliqué sur les électrodes de commande dont l'extrémité recouvre l'extrémité droite des électrodes de lecture, n'est pas toujours égal à $\phi_1$, mais du fait de l'inversion du sens de transfert de charge d'une rangée à une autre, est alternativement égal à $\phi_1$ et $\phi_2$. Ceci est montré sur la figure 5 pour deux électrodes de lecture 18 et 19 appartenant à deux rangées adjacentes.

Si l'on se réfère aux équations écrites lors de l'étude d'un filtre selon l'art antérieur, dans les expressions $\Sigma C_{r_1}\Delta\phi_1$ et $\Sigma C_{r_2}\Delta\phi_2$, les termes $\Sigma C_{r_1}$ et $\Sigma C_{r_2}$ peuvent alors se mettre sous la forme :

$$\sum C_{r_1} = \sum C_{r_{11}} + \sum C_{r_{12}}$$
$$\sum C_{r_2} = \sum C_{r_{21}} + \sum C_{r_{22}}$$

où $\Sigma C_{r_{11}}$ représente la somme des capacités dues au recouvrement d'extrémités droite d'électrodes de lecture par des électrodes de commande sur lesquelles est appliqué le potentiel $\phi$, $\Sigma C_{r_{12}}$ la somme des capacités dues au recouvrement d'extrémités gauche d'électrodes de lecture par des électrodes de commande sur lesquelles est appliqué le potentiel $\phi_1$, $\Sigma C_{r_{21}}$ la somme des capacités dues au recouvrement d'extrémités droite d'électrodes de lecture par des électrodes de commande sur lesquelles est appliqué le potentiel $\phi_2$, et $\Sigma C_{r_{22}}$ la somme des capacités dues au recouvrement d'extrémités gauche d'électrodes de lecture par des électrodes de commande sur lesquelles est appliqué le potentiel $\phi_2$.

Si l'on remarque maintenant que les largeurs de recouvrement $r_1$ et $r_2$ peuvent s'écrire respectivement $r + d$ et $r - d$, où d désigne le dépositionnement du recouvrement des deux extrémités d'une électrode de lecture par les deux électrodes de commande adjacentes, et r la largeur commune de recouvrement des deux extrémités de cette électrode de lecture, on peut écrire aves les mêmes notations que précédemment, et pour le cas où n est égal à 2

$$\sum C_{r_{11}} = \left[ \gamma \frac{W}{2} \left( \frac{N}{2M} + \delta \sum_{i=1}^{N/2M} h_i \right) + \gamma \frac{N}{2M} V \right] [r + d]$$

$$\sum C_{r_{12}} = \left[ \gamma \frac{W}{2} \left( \frac{N}{2M} + \delta \sum_{i=N/2M+1}^{N/M} h_i \right) + \gamma \frac{N}{2M} V \right] [r - d]$$

$$\sum C_{r_{21}} = \left[ \gamma \frac{W}{2} \left( \frac{N}{2M} + \delta \sum_{N/2M+1}^{N/M} h_i \right) + \gamma \frac{N}{2M} V \right] [r + d]$$

$$\sum C_{r_{22}} = \left[ \gamma \frac{W}{2} \left( \frac{N}{2M} + \delta \sum_{i=1}^{N/2M} h_i \right) + \gamma \frac{N}{2M} V \right] [r - d]$$

$$\sum_{i=1}^{N/2M} h_i \quad \text{et} \quad \sum_{i=N/2M+1}^{N/M} h_i$$

représentent respectivement la somme des coefficients de pondération rencontrés sur la première et sur la deuxième rangées. On peut dire avec une bonne approximation que la somme des coefficients rencontrés sur la première rangée est égale à la somme des coefficients rencontrés sur la deuxième rangée, et ceci est d'autant plus vrai que le nombre N/M de coefficients est grand.

La différence entre

$$\sum_{i=1}^{N/2M} h_i \quad \text{et} \quad \sum_{i=N/2M+1}^{N/M} h_i$$

est donc négligeable devant N/M, et l'on peut écrire :

$$\sum C_{r_1} = \sum C_{r_2} = \gamma r \frac{N}{M} \left( \frac{W}{2} + V \right) = \text{constante}$$

Les termes $\gamma$, N/M, W/2 et v sont des constantes invariables d'un filtre à un autre. Le terme r est également invariable d'un filtre à un autre, car au cours de la fabrication de ces filtres, le dépositionnement du masque d'un filtre à un autre se traduit non pas par une variation du paramètre r, mais par une variation du paramètre d.

Les termes $\Sigma C_{r_1}$ et $\Sigma C_{r_2}$ sont donc pratiquement constants. Ceci implique que la composante continue de lecture est pratiquement invariable d'un filtre à un autre, ce qui constitue bien l'effet recherché. On arriverait à la même conclusion pour un nombre de rangées multiple de 2.

Pour améliorer les performances du filtre conforme à l'invention le nombre de rangées d'un filtre élémentaire ne doit pas être choisi de manière quelconque, mais, comme cela été vu précédemment de manière a avoir une compensation de la somme des coefficients de pondération des rangées de numéro pair par la somme des coefficients de pondération des rangées de numéro impair.

Lorsque les N/n capacités MOS de chaque rangée sont disposées à leur tour en m sous-rangées, numérotées de 1 à m, les capacités MOS de chaque sous-rangée sont numérotées de 1 à N/m.n en suivant le sens de transfert de charge dans la sous-rangée numéro 1. La N/m.n capacité MOS de chaque sous-rangée de numéro impair est reliée à la N/m.n capacité MOS de la sous-rangée suivante. La première capacité MOS de chaque sous-rangée de numéro pair est reliée à la première capacité MOS de la sous-rangée suivante et les sens de transfert de charge dans deux sous-rangées adjacentes sont opposés. Dans ce cas les liaisons entre capacités MOS situées aux extrémités de sous-rangées adjacentes se font par l'intermédiaire de diodes reliées entre elles.

0 093 034

## Revendications

1. Filtre transversal à transfert de charge, comportant N capacités du type MOS disposées sur un même substrat semi-conducteur (1) et réparties en étages de retard, les capacités MOS de chaque étage de retard étant munies l'une d'une électrode de lecture (6), les autres d'électrodes de commande (3, 4, 5), et une électrode sur deux ayant ses extrémités recouvertes par les extrémités des deux électrodes adjacentes, caractérisé en ce que les N capacités MOS sont disposées en n rangées (avec n pair) numérotées de 1 à n, à raison de N/n capacités MOS par rangée, les capacités MOS de chaque rangée étant numérotées de 1 à N/n en suivant le sens de transfert de charge dans la rangée numéro 1, et les sens de transfert dans deux rangées adjacentes étant opposés, ce qui permet de compenser les effets dus aux décalages des masques utilisés pour la fabrication des filtres transversaux à transfert de charge.

2. Filtre selon la revendication 1, caractérisé en ce que la Nième/n capacité MOS de chaque rangée de numéro impair est reliée à la Nième/n capacité MOS de la rangée suivante, et en ce que la première capacité MOS de chaque rangée de numéro pair est reliée à la première capacité MOS de la rangée suivante.

3. Filtre selon la revendication 1, caractérisé en ce que les N/n capacités MOS de chaque rangée sont disposées à leur tour en m sous-rangée étant numérotées de 1 à N/mn en suivant le sens de transfert de charge dans la sous-rangée numéro 1, la Nième/mn capacité MOS de chaque sous-rangée de numéro impair étant reliée à la Nième/mn capacité MOS de la sous-rangée suivante, la première capacité MOS de chaque sous-rangée de numéro pair étant reliée à la première capacité MOS de la sous-rangée suivante, et les sens de transfert de charge dans deux sous-rangées adjacentes étant opposés.

4. Filtre selon la revendication 2, caractérisé en ce que les liaisons entre capacités MOS situées aux extrémités de rangées adjacentes se font par l'intermédiaire de diodes reliées entre elles.

5. Filtre selon la revendication 3, caractérisé en ce que les liaisons entre capacités MOS situées aux extrémités de sous-rangées adjacentes se font par l'intermédiaire de diodes reliées entre elles.

6. Filtre selon la revendication 1, caractérisé en ce que les étages d'entrée de deux rangées adjacentes sont situés à des extrémités opposées de ces deux rangées.

7. Filtre selon l'une des revendications 1 à 6, caractérisé en ce que les extrémités d'électrodes appartenant à des capacités MOS de même numéro sur différentes rangées sont alignées.

## Claims

1. Transverse load transfer filter comprising N capacities of MOS type arranged on the same semiconductor substrate (1) and distributed into delay stages, one of the MOS capacities of each delay stage being provided with a reading electrode (6) and the others with control electrodes (3, 4, 5), and one out of two electrodes having its ends covered by the ends of two adjacent electrodes, characterized in that the N MOS capacities are arranged in n lines (n being even) numbered from 1 to n, there being N/n MOS capacities per line, the MOS capacities of each line being numbered from 1 to N/n following the charge transfer direction in the line of number 1, and the transfer directions in two adjacent lines being opposed, thus permitting to compensate for effects which are due to offsets of the masks used for the production of the charge transfer transverse filters.

2. Filter according to claim 1, characterized in that the Nth/n MOS capacity of each line of odd number is connected to the Nth/n MOS capacity of the following line and in that the first MOS capacity of each line of even number is connected to the first MOS capacity of the following line.

3. Filter according to claim 1, characterized in that the N/n MOS capacities of each line are arranged in n sub-lines numbered from 1 to m, the MOS capacities of each sub-line being numbered from 1 to N/m.n following the charge transfer direction in the sub-line numbere 1, the Nth/m.n MOS capacity of each sub-line of odd number being connected to the Nth/m.n MOS capacity of the following sub-line, the first MOS capacity of each sub-line of even number being connected to the first MOS capacity of the following sub-line, and the charge transfer directions in two adjacent sub-lines being opposed.

4. Filter according to claim 2, characterized in that the connections between MOS capacities located at the ends od adjacent lines are made through interconnected diodes.

5. Filter according to claim 3, characterized in that the connections between MOS capacities located at the ends of adjacent sub-lines are made by interconnected diodes.

6. Filter according to claim 1, characterized in that the input stages of two adjacent lines are located at the opposed ends of these two lines.

7. Filter according to any of claims 1 to 6, characterized in that the ends of electrodes belonging to MOS capacities of the same number in different lines are aligned.

## Patentansprüche

1. Mit Ladungsüberführung arbeitendes Transversalfilter, welches N Kapazitäten vom MOS-Typ enthält, die auf demselben Halbleitersubstrat (1) angeordnet und auf Verzögerungsstufen verteilt sind, wobei von den MOS-Kapazitäten jeder Verzögerungsstufe die eine mit einer Leseelektrode (6) und die anderen mit Steuerelektroden (3, 4, 5) versehen sind und jeweils eine von zwei Elektroden Enden aufweist, welche durch die Enden der zwei benachbarten Elektroden bedeckt sind, dadurch gekennzeichnet, daß die N MOS-Kapazitäten in n Reihen (mit n geradzahlig) angeordnet sind, welche von 1 bis n numeriert sind, und zwar N/n MOS-Kapazitäten pro Reihe, wobei die MOS-Kapazitäten jeder Reihe von 1 bis N/n numeriert sind, indem sie dem Sinn der Ladungsüberführung in der Reihe mit der Nummer 1 folgen, während die Übertragungssinne in zwei aneinander angrenzenden Reihen einander entgegengesetzt sind, wodurch es ermöglicht wird, Effekte zu kompensieren, welche auf Versetzungen der Masken beruhen, welche zur Herstellung der mit Ladungsüberführung arbeitenden Transversalfilter verwendet werden.

2. Filter nach Anspruch 1, dadurch gekennzeichnet, daß die Nte/n MOS-Kapazität jeder Reihe einer ungeraden Nummer mit der Nte/n MOS-Kapazität der darauffolgenden Reihe verbunden ist und daß die erste MOS-Kapazität jeder Reihe gerader Zahl mit der ersten MOS-Kapazität der darauffolgenden Reihe verbunden ist.

3. Filter nach Anspruch 1, dadurch gekennzeichnet, daß die N/n MOS-Kapazitäten jeder Reihe ihrerseits in M Unterreihen angeordnet sind, welche von 1 bis m numeriert sind, wobei die MOS-Kapazitäten jeder Unterreihe von 1 bis N/m numeriert sind, wobei sie dem Ladungsübertragungssinn in der Unterreihe mit der Nummer 1 folgen, wobei die Nte/mn MOS-Kapazität der darauffolgenden Unterreihe verbunden ist, wobei die erste MOS-Kapazität jeder Unterreihe gerader Zahl mit der ersten MOS-Kapazität der darauffolgenden Unterreihe verbunden ist und wobei die Ladungsüberführungssinne in zwei aneinander angrenzenden Unterreihen entgegengesetzt sind.

4. Filter nach Anspruch 2, dadurch gekennzeichnet, daß die Verbindungen zwischen MOS-Kapazitäten, welche an den Enden von benachbarten Reihen liegen, über Dioden erfolgen, welche untereinander verbunden sind.

5. Filter nach Anspruch 3, dadurch gekennzeichnet, daß die Verbindungen zwischen MOS-Kapazitäten, welche an den Enden von benachbarten Unterreihen liegen, über Dioden erfolgen, welche untereinander verbunden sind.

6. Filter nach Anspruch 1, dadurch gekennzeichnet, daß die Eingangsstufen von zwei benachbarten Reihen an gegenüberliegenden Enden dieser zwei Reihen liegen.

7. Filter nach einem der Ansprüche 1 bis 6, dadurch gekennzeichnet, daß die Enden von Elektroden, welche zu MOS-Kapazitäten gleicher Nummer in verschiedenen Reihen gehören, ausgerichtet sind.

# FIG_1

# FIG_2

# FIG_3

# FIG_4

# FIG_5